# EUROPÄISCHE PATENTANMELDUNG

(11) **EP 4 810 912 A1**
(43) Veröffentlichungstag der Anmeldung: **23.09.2026**
(21) Anmeldenummer: 26162176.7
(22) Anmeldetag: 04.03.2026
(51) Int. Cl.: G01C 15/00, G01B 11/27

(54) **VERFAHREN ZUM DECKUNGSGLEICHEN AUSRICHTEN EINER DREHACHSE EINER SPINDEL EINES ROTATIONSLASERS ZU EINER LASERACHSE EINES VON EINER LASERDIODE ERZEUGTEN LASERSTRAHLS**

(30) Priorität: 20.03.2025 DE 102025110733
(71) Anmelder: Robert Bosch GmbH, 70442 Stuttgart (DE)
(72) Erfinder: Zibold, Tobias, 70567 Stuttgart (DE); Roehm, Tobias, 72218 Wildberg-Sulz (DE); Rindle, Stephan, 73765 Neuhausen (DE)

(57) **Zusammenfassung**

Ein Verfahren zum deckungsgleichen Ausrichten einer Drehachse (999) einer Spindel eines Rotationslasers zu einer Laserachse (912) eines von einer Laserdiode (135) einer Lasereinheit (130) des Rotationslasers erzeugten Laserstrahls (911), wobei der Rotationslaser eine Antriebseinheit mit einem Stator (210) und einem Rotor aufweist, wobei der Stator ein Trägerrohr aufweist, in dem die Spindel drehbeweglich gelagert ist und in dem ein der Laserdiode zugeordneter Laserdiodenhalter angeordnet ist, und wobei eine montagebedingte Schrägstellung und/oder ein seitlicher Versatz des Laserdiodenhalters im Trägerrohr eine Schrägstellung und/oder einen seitlichen Versatz der Laserachse des Laserstrahls relativ zur Drehachse der Spindel bewirkt, umfasst folgende Schritte:
• Vermessen der Laserachse zur Bestimmung einer vorliegenden Schrägstellung und/oder eines seitlichen Versatzes der Laserachse relativ zur Drehachse, und
• bei Vorliegen einer Schrägstellung und/oder eines seitlichen Versatzes der Laserachse relativ zur Drehachse, Justierdrehen von mindestens einer dem Trägerrohr zugeordneten Fläche zum Ausgleichen der vorliegenden Schrägstellung und/oder des seitlichen Versatzes.

## Beschreibung

### Stand der Technik

Die vorliegende Erfindung betrifft ein Verfahren zum deckungsgleichen Ausrichten einer Drehachse einer Spindel eines Rotationslasers zu einer Laserachse eines von einer Laserdiode einer Lasereinheit des Rotationslasers erzeugten Laserstrahls, wobei der Rotationslaser eine Antriebseinheit mit einem Stator und einem Rotor aufweist, wobei der Stator ein Trägerrohr aufweist, in dem die Spindel drehbeweglich gelagert ist und in dem ein der Laserdiode zugeordneter Laserdiodenhalter angeordnet ist, und wobei eine montagebedingte Schrägstellung und/oder ein seitlicher Versatz des Laserdiodenhalters im Trägerrohr eine Schrägstellung und/oder einen seitlichen Versatz der Laserachse des Laserstrahls relativ zur Drehachse der Spindel bewirkt.

Aus dem Stand der Technik ist ein Verfahren zum Ausrichten einer Drehachse einer Spindel eines Rotationslasers zu einer Laserachse eines von einer Laserdiode einer Lasereinheit des Rotationslasers erzeugten Laserstrahls bekannt. Der Rotationslaser weist eine Antriebseinheit mit einem Stator und einem Rotor auf, wobei der Stator ein Trägerrohr aufweist, in dem die Spindel drehbeweglich gelagert ist und in dem ein der Laserdiode zugeordneter Laserdiodenhalter angeordnet ist, und wobei eine montagebedingte Schrägstellung und/oder ein seitlicher Versatz des Laserdiodenhalters im Trägerrohr eine Schrägstellung und/oder einen seitlichen Versatz der Laserachse des Laserstrahls relativ zur Drehachse der Spindel bewirkt. Ein Ausgleich der Schrägstellung und/oder eines seitlichen Versatzes erfolgt über einen manuellen Justiervorgang.

### Offenbarung der Erfindung

Die Erfindung betrifft ein Verfahren zum deckungsgleichen Ausrichten einer Drehachse einer Spindel eines Rotationslasers zu einer Laserachse eines von einer Laserdiode einer Lasereinheit des Rotationslasers erzeugten Laserstrahls, wobei der Rotationslaser eine Antriebseinheit mit einem Stator und einem Rotor aufweist, wobei der Stator ein Trägerrohr aufweist, in dem die Spindel drehbeweglich gelagert ist und in dem ein der Laserdiode zugeordneter Laserdiodenhalter angeordnet ist, und wobei eine montagebedingte Schrägstellung und/oder ein seitlicher Versatz des Laserdiodenhalters im Trägerrohr eine Schrägstellung und/oder einen seitlichen Versatz der Laserachse des Laserstrahls relativ zur Drehachse der Spindel bewirkt. Das Verfahren weist folgende Schritte auf:
- Vermessen der Laserachse zur Bestimmung einer vorliegenden Schrägstellung und/oder eines seitlichen Versatzes der Laserachse relativ zur Drehachse, und
- bei Vorliegen einer Schrägstellung und/oder eines seitlichen Versatzes der Laserachse relativ zur Drehachse, Justierdrehen von mindestens einer dem Trägerrohr zugeordneten Fläche zum Ausgleichen der vorliegenden Schrägstellung und/oder des seitlichen Versatzes zur deckungsgleichen Ausrichtung der Laserachse mit der Drehachse.

Die Erfindung ermöglicht somit die Bereitstellung eines Verfahrens zum deckungsgleichen Ausrichten einer Drehachse einer Spindel eines Rotationslasers zu einer Laserachse eines von einer Laserdiode einer Lasereinheit des Rotationslasers erzeugten Laserstrahls, bei dem durch das Justierdrehen eine einfache und exakte Justierung ermöglicht werden kann.

Bevorzugt weist das Vermessen der Laserachse folgende Schritte auf:
- Aufnehmen eines rotierenden Laserstrahls in einer zur Drehachse der Spindel senkrechten ersten Ebene und in einer zur Drehachse der Spindel senkrechten zweiten Ebene, wobei die erste und zweite Ebene in unterschiedlichen Abständen zur Laserdiode angeordnet sind,
- Ermitteln eines Mittelpunkts des rotierenden Laserstrahls in der ersten und zweiten Ebene zur Definition einer zugeordneten Drehachse des Laserstrahls,
- Aufnehmen eines ersten, dem ersten rotierenden Laserstrahl zugeordneten Laserpunkts in einem ersten Rotationswinkel des ersten rotierenden Laserstrahls, und Aufnehmen eines zweiten, dem zweiten rotierenden Laserstrahl zugeordneten Laserpunkts in einem zweiten Rotationswinkel des zweiten rotierenden Laserstrahls, wobei der erste und zweite Rotationswinkel identisch sind, und
- Ermitteln der vorliegenden Schrägstellung und/oder des seitlichen Versatzes der Laserachse relativ zur Drehachse mittels des aufgenommenen ersten und zweiten Laserpunkts.

Somit kann sicher und zuverlässig eine vorliegende Schrägstellung und/oder ein seitlicher Versatz der Laserachse relativ zur Drehachse ermittelt werden.

Vorzugsweise weist das Justierdrehen folgende Schritte auf:
- Bearbeiten der mindestens einen dem Trägerrohr zugeordneten Fläche beruhend auf einer durch die Laserachse definierten virtuellen Drehachse.

Somit kann auf einfache Art und Weise ein geeignetes Justierdrehen ermöglicht werden.

Bevorzugt weist das Trägerrohr mindestens eine innere Lagerfläche zur drehbeweglichen Lagerung der Spindel auf, welche die dem Trägerrohr zugeordnete Fläche ausbildet und zur konzentrischen Ausrichtung der Spindel zum Laserstrahl mittels Justierdrehen bearbeitet wird.

Somit kann einfach und unkompliziert eine konzentrische Ausrichtung des Trägerrohrs ermöglicht werden.

Vorzugsweise weist das Trägerrohr an seinem Außenumfang mindestens eine äußere Anlagefläche zur Anlage an einer Grundplatte des Rotationslasers auf, welche die dem Trägerrohr zugeordnete Fläche ausbildet und zur zentrischen Ausrichtung der Spindel relativ zur Grundplatte mittels Justierdrehen bearbeitet wird.

Somit kann leicht und zuverlässig eine zentrische Ausrichtung der Spindel relativ zur Grundplatte ermöglicht werden.

Bevorzugt weist das Trägerrohr an seinem von der Spindel abgewandten Ende einen Umfangskragen auf und an einer der Spindel zugewandten Oberseite des Umfangskragens ist mindestens eine Anlagefläche zur Anlage an einer Grundplatte des Rotationslasers angeordnet, welche die dem Trägerrohr zugeordnete Fläche ausbildet und zur orthogonalen Ausrichtung der Spindel relativ zur Grundplatte mittels Justierdrehen bearbeitet wird.

Somit kann auf einfache Art und Weise eine orthogonale Ausrichtung der Spindel relativ zur Grundplatte ermöglicht werden.

Darüber hinaus betrifft die vorliegende Erfindung einen Rotationslaser mit einer Antriebseinheit zur Rotation eines Laserstrahls, welche einen Stator und einen Rotor zum rotierenden Antrieb einer Spindel um eine zugeordnete Drehachse aufweist, wobei der Stator ein Trägerrohr aufweist, in dem die Spindel drehbeweglich gelagert ist und in dem ein mit einer Laserdiode versehener Laserdiodenhalter angeordnet ist, und wobei die Laserdiode den Laserstrahl erzeugt. Das Trägerrohr ist zum deckungsgleichen Ausrichten der Drehachse der Spindel zum Laserstrahl der Laserdiode mittels Justierdrehen bearbeitet.

Die Erfindung ermöglicht somit die Bereitstellung eines Rotationslasers, bei dem durch das Justierdrehen eine einfache und exakte Justierung ermöglicht werden kann.

Bevorzugt sind in einer Innenaufnahme des Trägerrohrs mindestens zwei Lagerflächen zur Anordnung von Lagerelementen zum drehbeweglichen Lagern der Spindel vorgesehen, wobei das Trägerrohr an zumindest einer der mindestens zwei Lagerflächen zur konzentrischen Ausrichtung der Spindel zum Laserstrahl mittels Justierdrehen bearbeitet ist.

Somit kann leicht und unkompliziert eine konzentrische Ausrichtung der Spindel zum Laserstrahl ermöglicht werden.

Vorzugsweise ist eine Grundplatte zur Anordnung des Trägerrohrs vorgesehen, wobei das Trägerrohr dazu ausgebildet ist, zumindest abschnittsweise in eine zentrale Ausnehmung der Grundplatte einzugreifen.

Somit kann auf einfache Art und Weise eine geeignete Anordnung des Trägerrohrs bereitgestellt werden.

Bevorzugt weist das Trägerrohr an seinem Außenumfang eine erste Anlagefläche auf, wobei die erste Anlagefläche in der zentralen Ausnehmung angeordnet ist und wobei das Trägerrohr an der ersten Anlagefläche zur zentrischen Ausrichtung der Spindel relativ zur Grundplatte mittels Justierdrehen bearbeitet ist.

Somit kann einfach und zuverlässig eine zentrische Ausrichtung der Spindel relativ zur Grundplatte ermöglicht werden.

Vorzugsweise weist das Trägerrohr an einer Oberseite eines Umfangskragens eine zweite Anlagefläche auf, wobei die zweite Anlagefläche an einer Unterseite der Grundplatte angeordnet ist, und wobei das Trägerrohr an der zweiten Anlageflächen zur orthogonalen Ausrichtung der Spindel relativ zur Grundplatte mittels Justierdrehen bearbeitet ist.

Somit kann leicht und unkompliziert eine zentrische Ausrichtung der Spindel relativ zur Grundplatte ermöglicht werden.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
- Fig. 1: eine perspektivische Ansicht eines erfindungsgemäßen Rotationslasers mit einer Lasereinheit,
- Fig. 2: eine Schnittansicht eines dem Rotationslaser von Fig. 1 zugeordneten Stators mit einem Laserdiodenhalter und der Lasereinheit,
- Fig. 3: eine perspektivische Ansicht einer dem Rotationslaser von Fig. 1 zugeordneten Grundplatte mit dem Stator von Fig. 2 und zwei dem Rotationslaser zugeordneten Neigungssensoren,
- Fig. 4: eine perspektivische Schnittansicht einer Einpressvorrichtung mit dem Laserdiodenhalter und dem Stator von Fig. 2 und Fig. 3,
- Fig. 5: eine Schnittansicht einer Einpressvorrichtung mit dem Laserdiodenhalter und dem Stator von Fig. 4,
- Fig. 6: eine perspektivische Ansicht eines der Einpressvorrichtung von Fig. 4 und Fig. 5 zugeordneten Halteteils und des Laserdiodenhalters von Fig. 2 bis Fig. 5 in einer ersten Position,
- Fig. 7: eine perspektivische Ansicht des Halteteils und des Laserdiodenhalters von Fig. 6 in einer weiteren Position,
- Fig. 8: eine perspektivische Ansicht des Halteteils von Fig. 4 bis Fig. 7,
- Fig. 9: eine perspektivische Ansicht des Laserdiodenhalters von Fig. 2 bis Fig. 6 von einer Unterseite aus gesehen,
- Fig. 10: eine Schnittansicht des Stators mit dem Laserdiodenhalter von Fig. 2 bis Fig. 6, und
- Fig. 11: eine schematische Ansicht eines Vermessungsvorgangs für ein Justierdrehen.

### Beschreibung der Ausführungsbeispiele

In den Figuren werden Elemente mit gleicher oder vergleichbarer Funktion mit identischen Bezugszeichen versehen und nur einmal genauer beschrieben.

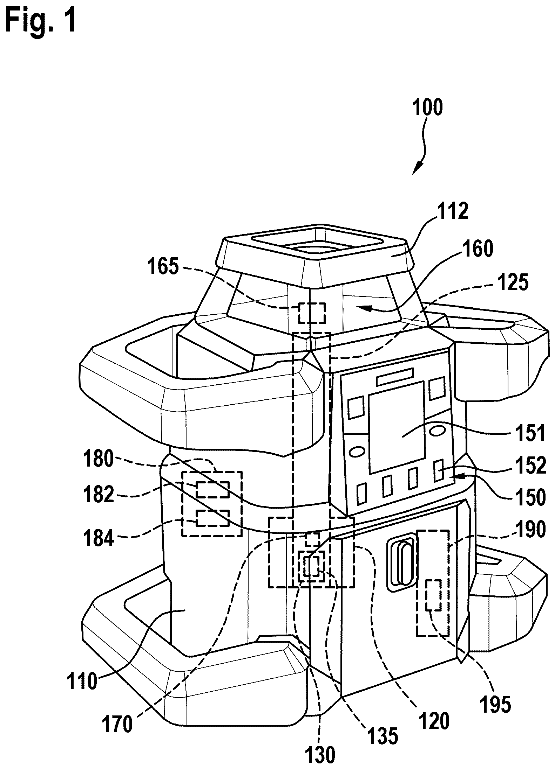

Fig. 1 zeigt einen beispielhaften Rotationslaser 100 mit einem Gehäuse 110, in dem eine Lasereinheit 130 mit einer Laserdiode 135 zur Erzeugung eines Laserstrahls angeordnet ist. Unter einem "Rotationslaser" kann im Kontext der vorliegenden Erfindung auch ein Baulaser oder ein Nivellierlaser verstanden werden. Des Weiteren ist in dem Gehäuse 110 beispielhaft eine Antriebseinheit 120 zum rotierenden Antrieb einer Spindel 125 angeordnet.

Die Lasereinheit 130 ist illustrativ derart an der Spindel 125 angeordnet, dass durch eine Rotation der Spindel 125 der von der Lasereinheit 130 erzeugte Laserstrahl in einer zugeordneten Ebene rotiert. Hierzu ist der Spindel 125 vorzugsweise ein Rotationskopf 160 mit einem Strahlenumleiter 165 zugeordnet. Der Strahlenumleiter 165 ist bevorzugt dazu ausgebildet, den Laserstrahl umzulenken, wodurch der Laserstrahl die zugeordnete Ebene projiziert. Je nach Bauart des Rotationslasers 100 kann die projizierte Ebene horizontal, vertikal oder z.B. mit einem definierten Neigungswinkel zur Erdoberfläche verlaufen. Vorzugsweise ist die Antriebseinheit 120 als Elektromotor ausgebildet.

Darüber hinaus ist in dem Gehäuse 110 bevorzugt eine Elektronikeinheit 190 mit einer Regelungs- und Überwachungsvorrichtung 195 angeordnet. Die Regelungs- und Überwachungsvorrichtung 195 ist vorzugsweise zur Regelung einer Laserleistung der Lasereinheit 130 in Abhängigkeit von einer Betriebsart ausgebildet. Hierbei wird eine Rotationsgeschwindigkeit der Spindel 125 der Antriebseinheit 120 gesteuert oder geregelt. Hierzu ist der Spindel 125 bevorzugt eine Ermittlungseinheit 170 zugeordnet.

Gemäß einer Ausführungsform ist dem Gehäuse 110 ein dem Rotationskopf 160 zugeordneter Schutzkäfig 112 zum Schutz vor einem Anschlagen des Rotationskopfs 160 zugeordnet.

Der Elektronikeinheit 190 ist bevorzugt eine Bedieneinheit 150 mit einem Display 151 und einer Eingabeeinheit 152 zugeordnet. Die Bedieneinheit 150 ist dabei bevorzugt steuer- oder regeltechnisch mit der Elektronikeinheit 190, insbesondere mit der Regelungs- und Überwachungsvorrichtung 195, verbunden. Die Eingabeeinheit 152 umfasst vorzugsweise zumindest ein Tastenfeld. Alternativ weist die Eingabeeinheit 152 einen Drehregler, einen Touchscreen, einen Schieberegler, eine Fernbedienung oder dergleichen auf. Über die Eingabeeinheit 152 ist durch einen Nutzer z.B. eine Rotationsgeschwindigkeit für die Spindel 125 eingebbar. Alternativ ist die Rotationsgeschwindigkeit der Lasereinheit 130 in einer Betriebsart automatisch regelbar.

Vorzugsweise weist der Rotationslaser 100 eine Nivelliereinheit 180 auf. Die Nivelliereinheit 180 weist bevorzugt zumindest einen Neigungssensor 184 auf, der dazu ausgebildet ist, eine Neigung des Rotationskopfs 160, insbesondere des Strahlenumleiters 165, und/oder der Lasereinheit 130 zu einer vorgegebenen, bevorzugt horizontalen Richtung bzw. zu einem Lot zu bestimmen. Darüber hinaus weist die Nivelliereinheit 180 vorzugsweise mindestens einen Neigungseinstellmotor 182 auf, der dazu ausgebildet ist, den Rotationskopf 160, insbesondere den Strahlenumleiter 165, und/oder die Lasereinheit 130, in Abhängigkeit von einer mittels des zumindest einen Neigungssensors 184 bestimmten Lage, vorzugsweise einer Neigung der Lasereinheit 130 und/oder des Rotationskopfs 160, bevorzugt zum Lot auszurichten.

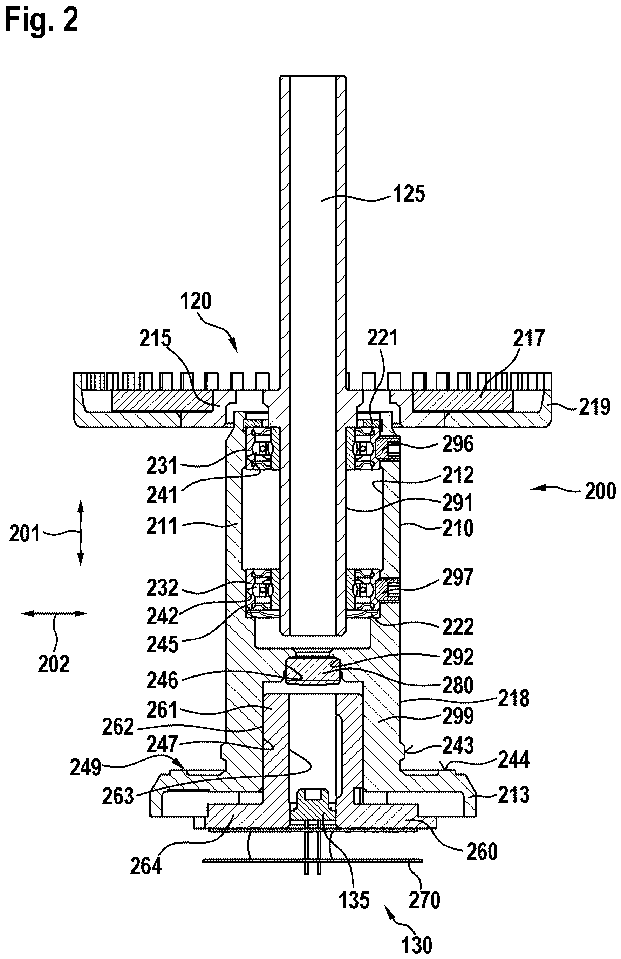

Fig. 2 zeigt die Spindel 125 von Fig. 1, die illustrativ mittels einer Lageranordnung 200 in einem der Antriebseinheit 120 von Fig. 1 zugeordneten Stator 210 gelagert ist. Der Stator 210 weist beispielhaft ein zylindrisches Trägerrohr 211 mit einer Innenaufnahme 212 auf. In der Innenaufnahme 212 ist illustrativ die Lageranordnung 200 mit zwei Lagerelementen 231, 232 zur Lagerung der Spindel 125 angeordnet.

Bevorzugt weist der Stator 210 mindestens eine Ausnehmung auf, die senkrecht zur Innenaufnahme 212 angeordnet ist. Die mindestens eine Ausnehmung ist illustrativ entlang einer Längserstreckung 201 der Spindel 125 im Bereich mindestens einer Lagerfläche 241, 242 angeordnet. Bevorzugt ist zwischen einem der mindestens einen Ausnehmung zugeordneten Klemmelement 296, 297 und einem Außenumfang eines der zwei Lagerelemente 231, 232 eine Klemmverbindung ausgebildet. Beispielhaft sind die Klemmelemente 296, 297 als Schrauben, insbesondere Madenschrauben, ausgebildet. Durch die Klemmelemente 296, 297 kann ein Spiel zwischen dem Stator 210 und den zwei Lagerelementen 231, 232 zumindest im Wesentlichen, d.h. im Rahmen gebräuchlicher Herstellungstoleranzen, eliminiert werden.

Illustrativ ist dem Lagerelement 231 eine obere Lagerfläche 241 zugeordnet und dem Lagerelement 232 ist eine untere Lagerfläche 242 zugeordnet. Vorzugsweise weist die somit dem illustrativ unteren Ende der Spindel 125 zugeordnete Lagerfläche 242 in der Innenaufnahme 212 eine Anlagefläche 245 zur Anlage des der Lagerfläche 242 zugeordneten Lagerelements 232 entlang der Längserstreckung 201 der Spindel 125 auf.

Darüber hinaus verdeutlicht Fig. 2 die Lasereinheit 130 von Fig. 1. Die Lasereinheit 130 weist illustrativ ein Lasermodulgehäuse 299 mit einer Innenaufnahme 247 zum Ausgeben bzw. Ausstrahlen eines durch die Laserdiode 135 erzeugten und kollimierten Laserstrahls auf. Das Lasermodulgehäuse 299 kann einstückig mit dem Stator 210 ausgebildet sein.

Zur Kollimation des Laserstrahls weist die Lasereinheit 130 vorzugsweise eine Kollimationslinse 280 auf. Hierbei ist die Kollimationslinse 280 bevorzugt in einem illustrativ oberen Aufnahmeabschnitt 246 der Innenaufnahme 292 des Lasermodulgehäuses 299 angeordnet und fixiert. Die Kollimationslinse 280 ist vorzugsweise mittels einer stoffschlüssigen Verbindung und/oder einer Pressverbindung in der Innenaufnahme 292, bzw. dem Aufnahmeabschnitt 246, fixiert.

Des Weiteren ist illustrativ ein Laserdiodenhalter 260 in der Innenaufnahme 292, insbesondere in einem illustrativ unteren Aufnahmeabschnitt 246, angeordnet. Bevorzugt ist dabei zumindest abschnittsweise zwischen einem Außenumfang 262 des Laserdiodenhalters 260 und dem Aufnahmeabschnitt 246 eine Pressverbindung ausgebildet.

Der Laserdiodenhalter 260 weist illustrativ eine Innenaufnahme 263 auf. In der Innenaufnahme 263 ist vorzugsweise die Laserdiode 135 zur Erzeugung eines Laserstrahls angeordnet. Die Laserdiode 135 ist bevorzugt auf einer Leiterplatte 270 angeordnet. Vorzugsweise ist die Leiterplatte 270 als flexible Leiterplatte ausgebildet. Illustrativ ist die Leiterplatte 270 an einer vom Stator 210 abgewandten Unterseite des Laserdiodenhalters 260 angeordnet. Bevorzugt ist die Leiterplatte 270 mittels einer stoffschlüssigen Verbindung am Laserdiodenhalter 260 fixiert. Gemäß einer Ausführungsform ist die stoffschlüssige Verbindung eine Klebeverbindung. Hierbei ist vorzugsweise das Klebemittel ein doppelseitiges Klebeband.

Bevorzugt ist der Spindel 125 die Ermittlungseinheit 170 von Fig. 1 zugeordnet. Die Ermittlungseinheit 170 weist beispielhaft eine Zahnscheibe 219 und eine nicht dargestellte Lichtschranke auf. Die Zahnscheibe 219 weist illustrativ eine Aufnahme zur zumindest teilweisen Aufnahme einer Magnetscheibe 217 auf. Die Magnetscheibe 217 bildet dabei beispielhaft einen Rotor der Antriebseinheit 120 aus.

Vorzugsweise weist die Spindel 125 ein Abdeckelement 215 auf. Das Abdeckelement 215 dient vorzugsweise als Lagersitz bzw. Magnetsitz. Bevorzugt ist die Spindel 125 mit dem Abdeckelement 215 verbunden. Hierbei ist das Abdeckelement 215 illustrativ an einem Außenumfang 291 der Spindel 125 angeordnet und erweitert die Spindel 125 in radialer Richtung 202 der Spindel 125. Vorzugsweise ist das Abdeckelement 215 scheibenförmig ausgebildet. Beispielhaft ist das Abdeckelement 215 einstückig mit der Spindel 125 ausgebildet. Die Zahnscheibe 219 und das Abdeckelement 215 bilden illustrativ die Aufnahme zur zumindest teilweisen Aufnahme der Magnetscheibe 217 aus. Hierbei ist die Zahnscheibe 219 vorzugsweise mit der Magnetscheibe 217 verbunden. Bevorzugt ist die Zahnscheibe 219 mit der Magnetscheibe 217 mittels einer Klebeverbindung verbunden. Alternativ ist das Abdeckelement 215 an der Spindel 125 befestigt.

Bevorzugt ist der Spindel 125 ein Arretierelement 221 zum Arretieren am Stator 210, bzw. im Trägerrohr 211, zugeordnet. Vorzugsweise ist entlang der Längserstreckung 201 der Spindel 125 zwischen dem Arretierelement 221 und einem jeweils zugeordneten Lagerelement 231, 232 der zwei Lagerelemente 231, 232 mindestens ein Federelement 222 angeordnet. Das Arretierelement 221 kann z.B. als Sprengring ausgebildet sein.

Vorzugsweise ist der Laserdiodenhalter 260 zumindest abschnittsweise in dem Trägerrohr 211 angeordnet. Der Laserdiodenhalter 260 weist beispielhaft einen rohrförmigen Grundkörper 261 mit der Innenaufnahme 263 auf, in der illustrativ die Laserdiode 135 angeordnet ist. Vorzugsweise weist der rohrförmige Grundkörper 261 des Laserdiodenhalters 260 einen Umfangskragen 264 auf. Der Umfangskragen 264 erstreckt sich illustrativ plattenförmig in radialer Richtung 202 vom rohrförmigen Grundkörper weg.

Bevorzugt weist das Trägerrohr 211 an seinem Außenumfang 218 eine erste Anlagefläche 243 und an einer Oberseite 249 eines Umfangskragens 213 eine zweite Anlagefläche 244 auf.

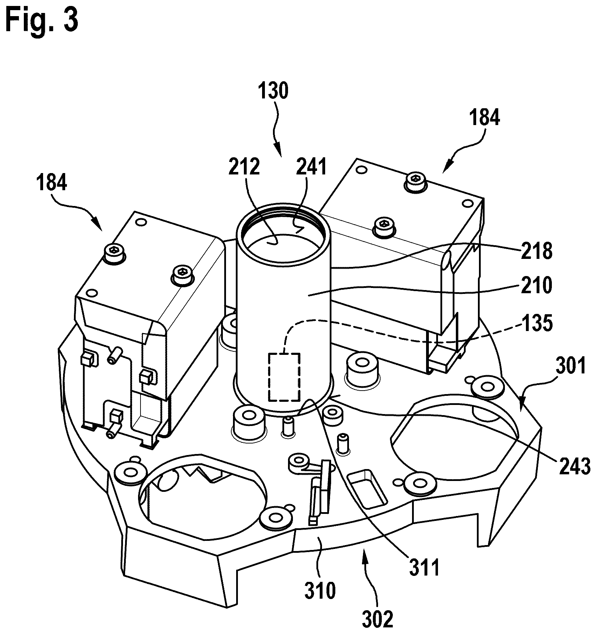

Fig. 3 zeigt eine dem Rotationslaser 100 von Fig. 1 zugeordnete Grundplatte 310. Die Grundplatte 310 ist bevorzugt im Gehäuse 110 des Rotationslasers 100 bewegbar gelagert. Die Grundplatte 310 weist eine Oberseite 301 und eine Unterseite 302 auf. Beispielhaft ist auf der Oberseite 301 mindestens ein, illustrativ zwei Neigungssensoren 184 der Nivelliereinheit 180 von Fig. 1 angeordnet.

Des Weiteren weist die Grundplatte 310 illustrativ eine zentrale Ausnehmung 311 auf. Die Grundplatte 310 ist vorzugsweise zur Anordnung des Trägerrohrs 211 von Fig. 2 vorgesehen. Hierbei ist das Trägerrohr 211 vorzugsweise dazu ausgebildet, zumindest abschnittsweise in die zentrale Ausnehmung 311 der Grundplatte 310 einzugreifen.

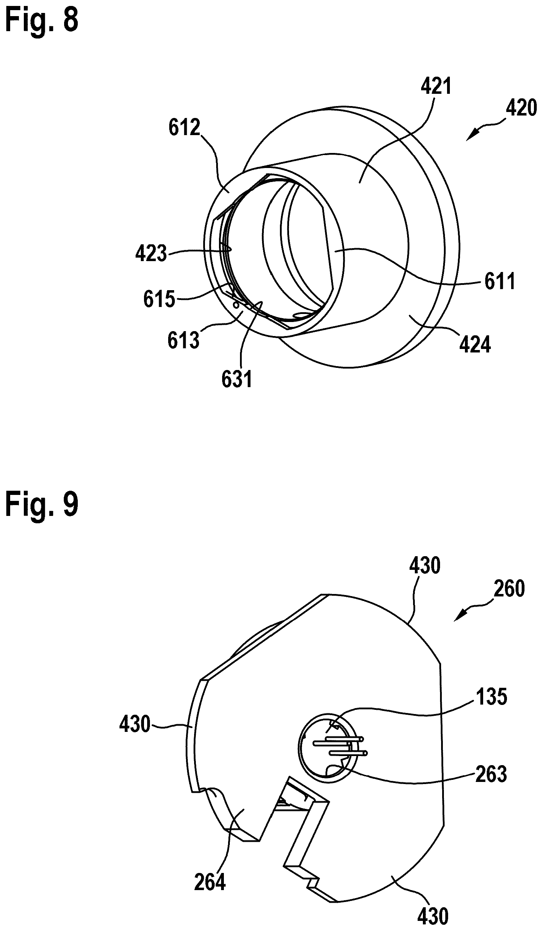

Bevorzugt ist die erste Anlagefläche 243 des Trägerrohrs 211 in der zentralen Ausnehmung 311 angeordnet. Des Weiteren ist die zweite Anlagefläche 244 bevorzugt an der Unterseite 302 der Grundplatte 310 angeordnet. Das Trägerrohr 211 ist vorzugsweise an mindestens einer der ersten und zweiten Anlageflächen 243, 244 zur orthogonalen Ausrichtung der Spindel 125 zu einem Laserstrahl (911 in Fig. 9) mittels Justierdrehen bearbeitet. Eine derartige Bearbeitung der ersten Anlagefläche 243 ermöglicht es, den Laserstrahl (911 in Fig. 9) zentrisch und orthogonal zur Grundplatte 310 auszurichten. Ferner werden die Lagerflächen 241, 242, die auch als Lagersitze bezeichnet werden können, zentrisch zur Grundplatte 310 ausgerichtet.

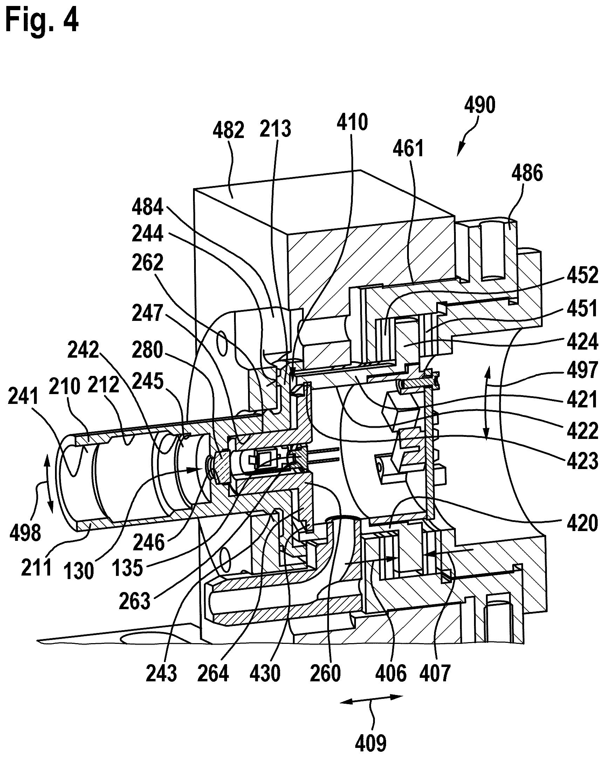

Fig. 4 zeigt eine beispielhafte Einpressvorrichtung 490 zum Einpressen des Laserdiodenhalters 260 von Fig. 2 in das Trägerrohr 211 von Fig. 2 bei einem Einpressvorgang. Der Stator 210 von Fig. 2, bzw. das Trägerrohr 211, ist hierbei bevorzugt mittels eines ersten Halteteils 484 an einer Haltevorrichtung 482 der Einpressvorrichtung 490 befestigt.

Der rohrförmige Grundkörper 261 des Laserdiodenhalters 260 weist, wie oben bei Fig. 2 beschrieben, den Umfangskragen 264 auf, der vorzugsweise in Umfangsrichtung 498 des Laserdiodenhalters 260 mindestens zwei radiale Erweiterungen 430 zur lösbaren Verbindung mit der Einpressvorrichtung 490 zum Einpressen des Laserdiodenhalters 260 in das Trägerrohr 211 aufweist. Vorzugsweise ist die lösbare Verbindung zur Übertragung von Druck- und/oder Zugkräften ausgebildet. Dies ist beispielhaft durch Pfeile 406, 407 dargestellt. Insbesondere ist die lösbare Verbindung vorzugsweise als lösbare Bajonett-Verbindung 410 ausgebildet. Bevorzugt sind die mindestens zwei radialen Erweiterungen 430 zur Ausbildung der lösbaren Bajonett-Verbindung 410 mit der Einpressvorrichtung 490 ausgebildet.

Des Weiteren weist die Einpressvorrichtung 490 illustrativ das erste Halteteil 484 zum Halten des Trägerrohrs 211 und ein zweites Halteteil 420 zum Halten des Laserdiodenhalters 260 auf. Das zweite Halteteil 420 weist bevorzugt in Umfangsrichtung 497 abschnittsweise mindestens einen Hinterschnitt 423 zur Ausbildung einer lösbaren Verbindung mit der Lasereinheit 130 auf. Zur Ausbildung der Bajonett-Verbindung 410 werden vorzugsweise die mindestens zwei radialen Erweiterungen 430 im mindestens einen Hinterschnitt 423 angeordnet. Der mindestens eine Hinterschnitt 423 des zweiten Halteteils 420 ist vorzugsweise abschnittsweise in Umfangsrichtung 497 des zweiten Halteteils 420 ausgebildet.

Das zweite Halteteil 420 weist illustrativ einen zylindrischen Grundkörper 421 mit einer Innenaufnahme 422 auf. An seinem illustrativ linken Ende weist die Innenaufnahme 422 den Hinterschnitt 423 auf. An seinem illustrativ rechten Ende weist das zweite Halteteil 420 illustrativ einen Umfangskragen 424 auf. Vorzugsweise ist das zweite Halteteil 420 über den Umfangskragen 424 mittels Lagerelementen 451, 452 in der Einpressvorrichtung 490, insbesondere einer Halterung 486, gelagert. Die Halterung 486 ist beispielhaft über eine Gewindeverbindung 461 in der Haltevorrichtung 482 angeordnet. Bevorzugt weist die Gewindeverbindung 461 ein Feingewinde auf.

Ein Einpressen des Laserdiodenhalters 260 in die Innenaufnahme 212 des Stators 210 erfolgt dabei vorzugsweise entlang einer Längserstreckung 409 des Stators 210 durch ein Kraftbeaufschlagen des ersten Halteteils 420 relativ zum zweiten Halteteil 484.

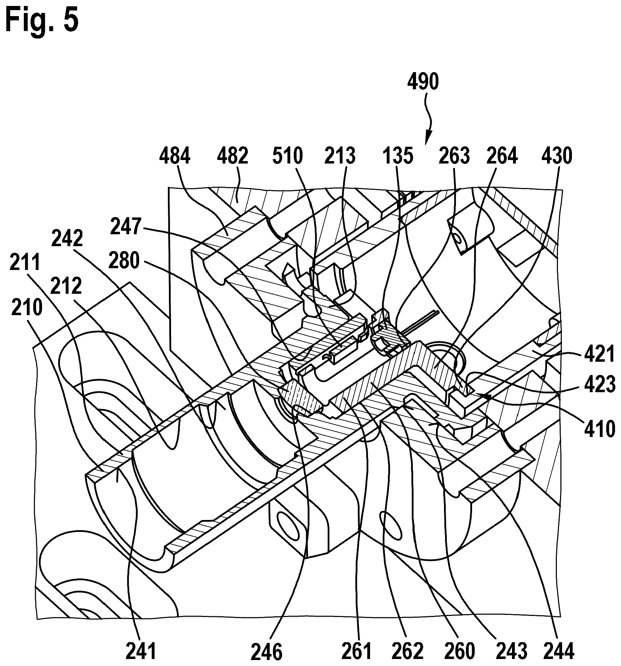

Fig. 5 zeigt die Einpressvorrichtung 490 und den Laserdiodenhalter 260 sowie das Trägerrohr 211 von Fig. 4. Der Laserdiode 135 ist vorzugsweise eine Monitordiode zugeordnet. Die Monitordiode ist vorzugsweise zur Messung einer der Laserdiode 135 zugeordneten Laserleistung ausgebildet. Hierbei kann die Monitordiode eine in die Laserdiode 135 integrierte Monitordiode sein. Bevorzugt weist die Lasereinheit 130 eine Fotodiode 510 auf, die für eine von der Monitordiode unabhängige Messung der Laserleistung vorgesehen ist. Illustrativ ist die Fotodiode 510 senkrecht zur Laserdiode 135 angeordnet.

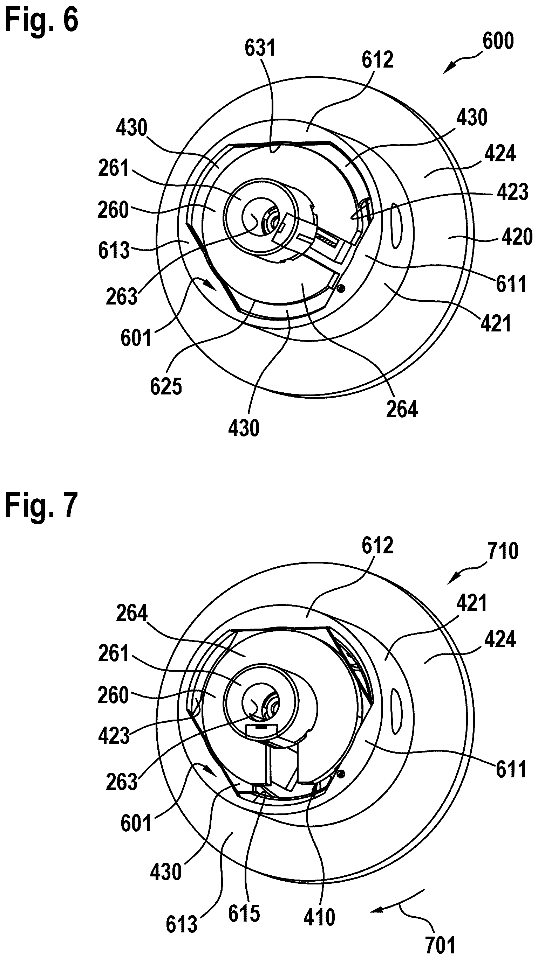

Fig. 6 zeigt das zweite Halteteil 420 der Einpressvorrichtung 490 von Fig. 4 und Fig. 5 mit dem Laserdiodenhalter 260 von Fig. 2 bis Fig. 5 in einer Fügeposition 600. Vorzugsweise weist der Laserdiodenhalter 260 mindestens zwei, illustrativ drei radiale Erweiterungen 430 auf. Analog hierzu weist das zweite Halteteil 420 vorzugsweise an seiner Stirnseite 601 eine dem Laserdiodenhalter 260 bzw. den illustrativ drei radialen Erweiterungen 430 zugeordnete Ausnehmung 615 auf. Bevorzugt weist das zweite Halteteil 420 an seiner Stirnseite 601 drei Abdeckstege 611, 612, 613 auf, die den Hinterschnitt 423 abschnittsweise verdecken. Des Weiteren weist die Ausnehmung 615 illustrativ mittig eines Abdeckstegs 611, 612, 613 eine Ausbuchtung 631 auf, die einem Außenumfang 625 des Umfangskragens 264 des Laserdiodenhalters 260 zugeordnet ist.

Fig. 7 zeigt das zweite Halteteil 420 der Einpressvorrichtung 490 mit dem Laserdiodenhalter 260 von Fig. 6 in einer arretierten Position 700. In Fig. 7 sind das zweite Halteteil 420 und der Laserdiodenhalter 260 illustrativ in Umfangsrichtung 701 zur Fügeposition 600 in Fig. 6 zueinander verdreht angeordnet. Vorzugsweise sind das zweite Halteteil 420 und der Laserdiodenhalter 260 in Umfangsrichtung 701 um 60° zueinander verdreht.

In der arretierten Position 700 sind die illustrativ drei radialen Erweiterungen 430 des Laserdiodenhalters 260 beispielhaft im Hinterschnitt 423 angeordnet, wobei die Abdeckstege 611, 612, 613 die radialen Erweiterungen 430 in den Hinterschnitt 423 beaufschlagen. Hierbei bilden illustrativ der Laserdiodenhalter 260 und das zweite Halteteil 420 die Bajonett-Verbindung 410 aus.

Bei einem beispielhaften Verfahren zur Montage des Laserdiodenhalters 260 der Lasereinheit 130 des Rotationslasers 100 im Trägerrohr 211 des Stators 210 erfolgt vorzugsweise zuerst ein Anordnen des Laserdiodenhalters 260 in der Fügeposition 600 von Fig. 6 am zweiten Halteteil 420 der Einpressvorrichtung 490 von Fig. 4 und Fig. 5. Anschließend erfolgt ein Verdrehen des Laserdiodenhalters 260 um einen vorgegebenen Verdrehwinkel entlang der Umfangsrichtung 701 zur Anordnung in der arretierten Position 700, in der der Laserdiodenhalter 260 und das zweite Halteteil 420 die Bajonett-Verbindung 410 ausbilden. Ebenfalls erfolgt ein Fixieren des Stators 210 am ersten Halteteil 484 der Einpressvorrichtung 490. Danach findet das Einpressen des Laserdiodenhalters 260 in die **In**nenaufnahme 212 des Stators 210 entlang der Längserstreckung 409 des Stators 210 durch ein Kraftbeaufschlagen des zweiten Halteteils 420 relativ zum ersten Halteteil 484 statt. Anschließend erfolgt ein Verdrehen des Laserdiodenhalters 260 gegenüber der Einpressvorrichtung 490 entgegen der Umfangsrichtung 701 zum Verdrehen des Laserdiodenhalters 260 von der arretierten Position 700 in die Fügeposition 600. Abschließend findet ein Entfernen des ersten und zweiten Halteteils 484, 420 vom Laserdiodenhalter 260 und dem Trägerrohr 211 des Stators 210 statt.

Wie oben beschrieben, werden vorzugsweise die mindestens zwei radialen Erweiterungen 430 des Laserdiodenhalters 260 zur Ausbildung der Bajonett-Verbindung 410 im mindestens einen Hinterschnitt 423 des zweiten Halteteils 420 angeordnet.

Fig. 8 zeigt das zweite Halteteil 420 von Fig. 4 bis Fig. 7 mit dem zylindrischen Grundkörper 421, dem Hinterschnitt 423 und dem Umfangskragen 424. Dabei verdeutlicht Fig. 8 die Ausnehmung 615 mit den Abdeckstegen 611, 612, 613 sowie der Ausbuchtung 631.

Fig. 9 zeigt den Laserdiodenhalter 260 von Fig. 2 bis Fig. 7. Dabei verdeutlicht Fig. 9 den Umfangskragen 264 des Laserdiodenhalters 260 mit den drei beispielhaften radialen Erweiterungen 430.

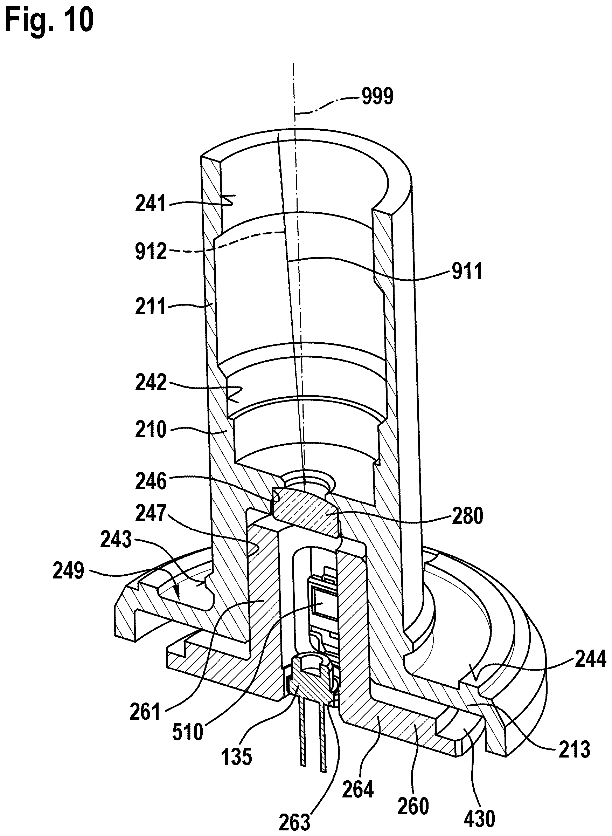

Fig. 10 zeigt den Stator 210 mit dem Trägerrohr 211 und den abschnittsweise im Trägerrohr 211 angeordneten Laserdiodenhalter 260 mit der Laserdiode 135, der Fotodiode 510 sowie der Kollimationslinse 280 von Fig. 2, Fig. 4 und Fig. 5. Ein durch die Laserdiode 135 erzeugter und durch die Kollimationslinse 280 kollimierter Laserstrahl 911 sowie eine dem Laserstrahl 911 zugeordnete Laserachse 912 sind illustrativ nicht deckungsgleich mit einer Drehachse 999 der Spindel bzw. des Trägerrohrs 211 angeordnet, sondern beispielhaft schräg hierzu gestellt. Eine derartige Schrägstellung und/oder ein seitlicher Versatz kann bei der Montage des Laserdiode 135 im Laserdiodenhalter 260, der Montage des Laserdiodenhalters 260 im Trägerrohr 211 und/oder bei der Montage der Kollimationslinse 280 im Trägerrohr 211 auftreten.

Um die Schrägstellung und/oder den seitlichen Versatz des Laserstrahls 911 zur Drehachse 999 innerhalb vorgegebener Toleranzen auszugleichen, bzw. zum deckungsgleichen Ausrichten der Drehachse 999 der Spindel 125 zum Laserstrahl 911 der Laserdiode 135, ist das Trägerrohr 211 bevorzugt mittels Justierdrehen bearbeitet.

In einem konventionellen Drehprozess wird ein Werkstück auf eine Spindel gespannt, die ortsfest ist und lediglich eine Rotation ausführen kann. Daher können nur rotationssymmetrische Geometrien erzeugt werden bzw. spiralförmige, beispielsweise Gewinde. Beim Justierdrehen kann die Spindel zusätzlich eine Seitwärtsbewegung ausführen. Die unterschiedlichen Bewegungen z.B. Rotation, Seitwärtsbewegung der Spindel, Vorschub des Werkzeugs, können über einen Rechner präzise gesteuert werden. Auf diese Weise können "unrunde" Konturen erzeugt werden. Diese Fähigkeit ermöglicht die Korrektur einer schrägen Laserachse, wie beispielhaft der Laserachse 912.

Wie oben beschrieben, sind in der Innenaufnahme 212 des Trägerrohrs 211 mindestens zwei Lagerflächen 241, 242 zur Anordnung der Lagerelemente 231, 232 zum drehbeweglichen Lagern der Spindel 125 von Fig. 1 und Fig. 2 vorgesehen. Vorzugsweise ist das Trägerrohr 211 an zumindest einer der mindestens zwei Lagerflächen 241, 242 zur konzentrischen Ausrichtung der Spindel 125 zum Laserstrahl 911 mittels Justierdrehen bearbeitet.

Des Weiteren weist das Trägerrohr 211, wie oben beschrieben, vorzugsweise am Außenumfang 218 die ersten Anlagefläche 243 und/oder an der Oberseite 249 des Umfangskragens 213 die zweite Anlagefläche 244 auf, wobei die erste Anlagefläche 243 beispielhaft in der zentralen Ausnehmung 311 von Fig. 3 angeordnet ist und die zweite Anlagefläche 244 an der Unterseite 302 der Grundplatte 310 angeordnet ist. Alternativ, oder optional, ist das Trägerrohr 211 an der ersten Anlagefläche 243 zur zentrischen Ausrichtung der Spindel 125 bzw. des Laserstrahls 911 relativ zur Grundplatte 310 in Fig. 3 mittels Justierdrehen bearbeitet. Alternativ, oder optional, ist das Trägerrohr 211 an der zweiten Anlagefläche 244 zur orthogonalen Ausrichtung der Spindel 125 bzw. des Laserstrahls 911 relativ zur Grundplatte 310 in Fig. 3 mittels Justierdrehen bearbeitet.

Vorzugsweise wird bei einem Justierdrehen des Stators 210, bzw. des Trägerrohrs 211, mindestens eine der dem Trägerrohr 211 zugeordneten Flächen 241, 242, 243, 244 beruhend auf einer durch die Laserachse 912 definierte, virtuelle Drehachse bearbeitet, insbesondere zerspanend bearbeitet. Hierbei bildet bevorzugt mindestens eine der Lagerflächen 241, 242 eine derartige zugeordnete Fläche aus. Alternativ, oder optional, bildet die erste und/oder zweite Anlagefläche 243, 244 eine derartige zugeordnete Fläche aus. Durch die Bearbeitung des Trägerrohrs 210 entlang der virtuellen Drehachse wird bevorzugt zumindest eine der zugeordneten Flächen 241, 242, 243, 244 derart bearbeitet, dass die Drehachse 999 der Spindel 125 deckungsgleich mit dem Laserstrahl 911 angeordnet ist.

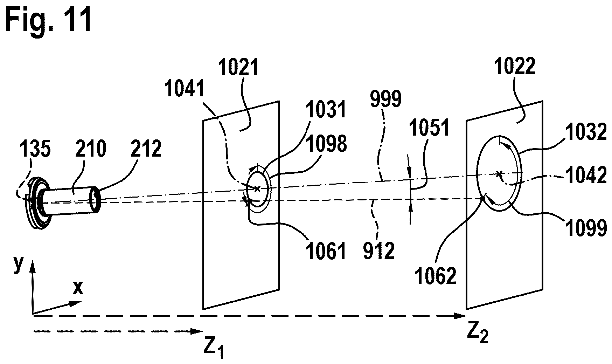

Fig. 11 zeigt den Stator 210 von Fig. 10 bei einem Verfahren zum deckungsgleichen Ausrichten der Drehachse 999 der Spindel 125 des Rotationslasers 100 zur Laserachse 912 des von der Laserdiode 135 der Lasereinheit 130 des Rotationslasers 100 erzeugten Laserstrahls 911.

Die montagebedingte Schrägstellung des Laserdiodenhalters 260 im Trägerrohr 211 bewirkt eine Schrägstellung und/oder einen seitlichen Versatz der Laserachse 912 des Laserstrahls 911 relativ zur Drehachse 999 der Spindel 125, wobei die Schrägstellung und/oder der seitliche Versatz mittels Justierdrehen ausgeglichen werden. Hierzu erfolgt zuerst ein Vermessen der Laserachse 912 zur Bestimmung der vorliegenden Schrägstellung und/oder des seitlichen Versatzes der Laserachse 912 relativ zur Drehachse 999.

Beim Vermessen der Laserachse 912 erfolgt zuerst ein Aufnehmen eines rotierenden Laserstrahls 1031, 1032 in einer zur Drehachse 999 der Spindel 125 senkrechten ersten Ebene 1021 und in einer zur Drehachse 999 der Spindel 125 senkrechten zweiten Ebene 1022. Hierbei sind die senkrechten Ebenen 1021, 1022 in unterschiedlichen Abständen z1, z2 zur Laserdiode 135 angeordnet. Anschließend erfolgt vorzugsweise ein Ermitteln eines Mittelpunkts 1041, 1042 des rotierenden Laserstrahls 1031, 1032 in der ersten und zweiten Ebene 1021, 1022 zur Definition einer zugeordneten Drehachse des Laserstrahls 1031, 1032. Danach kann ein Aufnehmen eines ersten, dem ersten rotierenden Laserstrahl 1031 zugeordneten Laserpunkts 1061 in einem ersten Rotationswinkel 1098 des ersten rotierenden Laserstrahls 1031, und ein Aufnehmen eines zweiten, dem zweiten rotierenden Laserstrahl 1032 zugeordneten Laserpunkts 1062 in einem zweiten Rotationswinkel 1099 des zweiten rotierenden Laserstrahls 1032 erfolgen. Der erste und zweite Rotationswinkel 1098, 1099 sind bevorzugt identisch. Abschließend erfolgt ein Ermitteln der vorliegenden Schrägstellung 1051 und/oder des seitlichen Versatzes der Laserachse 912 relativ zur Drehachse 999 mittels des aufgenommenen ersten und zweiten Laserpunkts 1061, 1062.

Bei einem Vorliegen einer Schrägstellung und/oder eines seitlichen Versatzes der Laserachse 912 relativ zur Drehachse 999 erfolgt das oben beschriebene Justierdrehen von mindestens einer dem Trägerrohr 211 zugeordneten Fläche 241, 242, 243, 244 zum Ausgleichen der vorliegenden Schrägstellung und/oder des seitlichen Versatzes zur deckungsgleichen Ausrichtung der Laserachse 912 mit der Drehachse 999.

## Patentansprüche

1. Verfahren zum deckungsgleichen Ausrichten einer Drehachse (999) einer Spindel (125) eines Rotationslasers (100) zu einer Laserachse (912) eines von einer Laserdiode (135) einer Lasereinheit (130) des Rotationslasers (100) erzeugten Laserstrahls (911), wobei der Rotationslaser (100) eine Antriebseinheit (120) mit einem Stator (210) und einem Rotor aufweist, wobei der Stator (210) ein Trägerrohr (211) aufweist, in dem die Spindel (125) drehbeweglich gelagert ist und in dem ein der Laserdiode (135) zugeordneter Laserdiodenhalter (260) angeordnet ist, und wobei eine montagebedingte Schrägstellung und/oder ein seitlicher Versatz des Laserdiodenhalters (260) im Trägerrohr (211) eine Schrägstellung und/oder einen seitlichen Versatz der Laserachse (912) des Laserstrahls (911) relativ zur Drehachse (999) der Spindel (125) bewirkt, welches Verfahren folgende Schritte aufweist:
• Vermessen der Laserachse (912) zur Bestimmung einer vorliegenden Schrägstellung und/oder eines seitlichen Versatzes der Laserachse (912) relativ zur Drehachse (999), und
• bei Vorliegen einer Schrägstellung und/oder eines seitlichen Versatzes der Laserachse (912) relativ zur Drehachse (999), Justierdrehen von mindestens einer dem Trägerrohr (211) zugeordneten Fläche (241, 242, 243, 244) zum Ausgleichen der vorliegenden Schrägstellung und/oder des seitlichen Versatzes zur deckungsgleichen Ausrichtung der Laserachse (912) mit der Drehachse (999).

2. Verfahren nach Anspruch 1, **dadurch gekennzeichnet, dass** das Vermessen der Laserachse (912) folgende Schritte aufweist:
• Aufnehmen eines rotierenden Laserstrahls (1031, 1032) in einer zur Drehachse (999) der Spindel (125) senkrechten ersten Ebene (1021) und in einer zur Drehachse (999) der Spindel (125) senkrechten zweiten Ebene (1022), wobei die erste und zweite Ebene (1021, 1022) in unterschiedlichen Abständen (z1, z2) zur Laserdiode (135) angeordnet sind,
• Ermitteln eines Mittelpunkts (1041, 1042) des rotierenden Laserstrahls (1031, 1032) in der ersten und zweiten Ebene (1021, 1022) zur Definition einer zugeordneten Drehachse des Laserstrahls (1031, 1032),
• Aufnehmen eines ersten, dem ersten rotierenden Laserstrahl (1031) zugeordneten Laserpunkts (1061) in einem ersten Rotationswinkel (1098) des ersten rotierenden Laserstrahls (1031), und Aufnehmen eines zweiten, dem zweiten rotierenden Laserstrahl (1032) zugeordneten Laserpunkts (1062) in einem zweiten Rotationswinkel (1099) des zweiten rotierenden Laserstrahls (1032), wobei der erste und zweite Rotationswinkel (1098, 1099) identisch sind, und
• Ermitteln der vorliegenden Schrägstellung und/oder des seitlichen Versatzes der Laserachse (912) relativ zur Drehachse (999) mittels des aufgenommenen ersten und zweiten Laserpunkts (1061, 1062).

3. Verfahren nach Anspruch 1 oder 2, **dadurch gekennzeichnet, dass** das Justierdrehen folgende Schritte aufweist:
• Bearbeiten der mindestens einen dem Trägerrohr (211) zugeordneten Fläche (241, 242, 243, 244) beruhend auf einer durch die Laserachse (912) definierten virtuellen Drehachse.

4. Verfahren nach einem der vorhergehenden Ansprüche, **dadurch gekennzeichnet, dass** das Trägerrohr (211) mindestens eine innere Lagerfläche (241, 242) zur drehbeweglichen Lagerung der Spindel (125) aufweist, welche die dem Trägerrohr (211) zugeordnete Fläche ausbildet und zur konzentrischen Ausrichtung der Spindel (125) zum Laserstrahl (911) mittels Justierdrehen bearbeitet wird.

5. Verfahren nach einem der vorhergehenden Ansprüche, **dadurch gekennzeichnet, dass** das Trägerrohr (211) an seinem Außenumfang (218) mindestens eine äußere Anlagefläche (243) zur Anlage an einer Grundplatte (310) des Rotationslasers (100) aufweist, welche die dem Trägerrohr (211) zugeordnete Fläche ausbildet und zur zentrischen Ausrichtung der Spindel (125) relativ zur Grundplatte (310) mittels Justierdrehen bearbeitet wird.

6. Verfahren nach einem der vorhergehenden Ansprüche, **dadurch gekennzeichnet, dass** das Trägerrohr (211) an seinem von der Spindel (125) abgewandten Ende einen Umfangskragen (213) aufweist und an einer der Spindel (125) zugewandten Oberseite (249) des Umfangskragens (213) mindestens eine Anlagefläche (244) zur Anlage an einer Grundplatte (310) des Rotationslasers (100) angeordnet ist, welche die dem Trägerrohr (211) zugeordnete Fläche ausbildet und zur orthogonalen Ausrichtung der Spindel (125) relativ zur Grundplatte (310) mittels Justierdrehen bearbeitet wird.

7. Rotationslaser (100) mit einer Antriebseinheit (120) zur Rotation eines Laserstrahls (911), welche einen Stator (210) und einen Rotor zum rotierenden Antrieb einer Spindel (125) um eine zugeordnete Drehachse (999) aufweist, wobei der Stator (210) ein Trägerrohr (211) aufweist, in dem die Spindel (125) drehbeweglich gelagert ist und in dem ein mit einer Laserdiode (135) versehener Laserdiodenhalter (260) angeordnet ist, und wobei die Laserdiode (135) den Laserstrahl (911) erzeugt, **dadurch gekennzeichnet, dass** das Trägerrohr (211) zum deckungsgleichen Ausrichten der Drehachse (999) der Spindel (125) zum Laserstrahl (911) der Laserdiode (135) mittels Justierdrehen bearbeitet ist.

8. Rotationslaser nach Anspruch 7, **dadurch gekennzeichnet, dass** in einer **In**nenaufnahme (212) des Trägerrohrs (211) mindestens zwei Lagerflächen (241, 242) zur Anordnung von Lagerelementen (231, 232) zum drehbeweglichen Lagern der Spindel (125) vorgesehen sind, wobei das Trägerrohr (211) an zumindest einer der mindestens zwei Lagerflächen (241, 242) zur konzentrischen Ausrichtung der Spindel (125) zum Laserstrahl (911) mittels Justierdrehen bearbeitet ist.

9. Rotationslaser nach Anspruch 7 oder 8, **dadurch gekennzeichnet, dass** eine Grundplatte (310) zur Anordnung des Trägerrohrs (211) vorgesehen ist, wobei das Trägerrohr (211) dazu ausgebildet ist, zumindest abschnittsweise in eine zentrale Ausnehmung (311) der Grundplatte (310) einzugreifen.

10. Rotationslaser nach Anspruch 9, **dadurch gekennzeichnet, dass** das Trägerrohr (211) an seinem Außenumfang (218) eine erste Anlagefläche (243) aufweist, wobei die erste Anlagefläche (243) in der zentralen Ausnehmung (311) angeordnet ist und wobei das Trägerrohr (211) an der ersten Anlagefläche (243) zur zentrischen Ausrichtung der Spindel (125) relativ zur Grundplatte (310) mittels Justierdrehen bearbeitet ist.

11. Rotationslaser nach Anspruch 9 oder 10, **dadurch gekennzeichnet, dass** das Trägerrohr (211) an einer Oberseite (249) eines Umfangskragens (213) eine zweite Anlagefläche (244) aufweist, wobei die zweite Anlagefläche (244) an einer Unterseite (302) der Grundplatte (310) angeordnet ist, und wobei das Trägerrohr (211) an der zweiten Anlagefläche (244) zur orthogonalen Ausrichtung der Spindel (125) relativ zur Grundplatte (310) mittels Justierdrehen bearbeitet ist.
